# EUROPEAN PATENT APPLICATION

(11) **EP 2 881 973 A1**
(43) Date of publication of application: **10.06.2015**
(21) Application number: 13195583.3
(22) Date of filing: 04.12.2013
(51) Int. Cl.: H01J 37/32, C23C 14/52, G01N 23/223, H05H 1/00

(54) **Device and method for pvd process diagnostic using X-ray fluorescence local probe**

(71) Applicant: Institute of Solid State Physics, University of Latvia, 1063 Riga (LV)
(72) Inventor: Purans, Juris, LV-1010 Riga (LV)
(74) Representative: Fortuna, Jevgenijs

(57) **Abstract**

The invention relates to a diagnostics of plasma and flux of sputtered or evaporated particles of material inside a chamber, which is maintained at a low pressure. There is offered a device and a method for 2D or 3D X-ray fluorescence mapping analysis of plasma and/or flux of sputtered or evaporated particles of material, where the device comprises: a probe unit placed outside or inserted into a plasma and/or a flux of sputtered or evaporated particles of material and adapted to direct signals from a signal supplying unit to a signal detecting unit; a means for processing the detected signals and interpreting the signals received, wherein the device comprises a source (2) adapted for generating plasma and/or creating a flux of sputtered or evaporated particles of material; a X-ray source (11) adapted to send a collimating beam (14) through the plasma and/or the flux of sputtered or evaporated particles; a movable X-ray fluorescence polycapillary confocal probe (5) provided with at least an x- and y- axis manipulator (6), the probe (5) comprising an X-ray optic (7), being accommodated in a casing (8); where the probe (5) is adapted to collect the XRF signal from an intersect (17) the beam (14) provided by the X-ray source (11) and projection (line of sight (16)) of the probe (5); a X-ray energy sensitive detector (4) being optically connected with the probe (5) to enable the X-ray optic (7) to direct X-rays towards the detector (4) from the optic's (7) input end facing the beam (14).

## Description

### Technical field

The present invention relates to the diagnostics of plasma and flux of sputtered or evaporated particles of material inside a chamber, which is maintained at a low pressure, and more particularly to measurement of the distribution of gas mixtures and sputtered or evaporated atoms within a physical vapour deposition (PVD) chamber.

### Background Art

Plasma diagnostics are different methods and tools used to measure and monitor properties of plasma, including plasma components density, distribution function over temperature, spatial profiles and dynamics. These properties enable to derive plasma parameters.

There is known a Langmuir multi-probe control circuit (CN 103140009) used for plasma diagnostics. The known control circuit is located outside a plasma device and comprises three Langmuir singleprobes, an alternating-current sawtooth wave supply voltage generation device, a direct-current supply voltage generation device, a double-pole-double-throw switch, a reversing switch, a first double-pole-three-throw switch, a second double-pole-three-throw switch, a first single-pole-single-throw switch, a second single-pole-single-throw switch and a transform resistor. Selection of the Langmuir single-probes, a double-probe, and a three-probe in different diagnosis circuits is carried out through switching-over of the switches in control circuits. The main drawback of the known multi-probe device is that it does not provide an absolute measurement of particle concentration.

There is known an RF electric field probe device (US 6806650) used for measuring an RF electric field intensity in a plasma. The device comprising an electric field sensing unit and an output unit, wherein the electric field sensing unit contains a first electrooptical component positionable in the plasma and operable to modulate light as a function of variations of the RF electric field in the plasma at the fundamental frequency and harmonics of the RF electric field, and a first antenna unit electrically coupled to the first component for coupling the first component to the RF electric field. The output unit is coupled to the electric field sensing unit for providing an output signal containing information relating to the magnitude and frequency of the modulation which occurs in the first component. The probe device may be used to map a plasma region by moving the probe device to any selected point in the plasma region. The main drawback of the known multi-probe device is that it also does not provide an absolute measurement of particle concentration.

Remote optical emission spectroscopy (OES) technique is also standard plasma sputtering diagnostic method to perform measuring of plasma parameters and provide sputtering process control. Local 3D low-temperature sputtering plasma mapping by plasma emission local optical detection probe (LOES - local optical emission spectroscopy), which is located directly in plasma area above magnetron and spatially scans plasma, is used to provide *in situ* a 3D process control and mapping (US6034781). A plasma probe enables simultaneous localized electrostatic and optical emission spectroscopy measurements. The probe has a support arm with an elongated longitudinally extending section and a bend section at the end of which is supported an electrical probe element composed of back-to-back charge collection plates separated by an insulating spacer. An optical fiber extends through the support arm and has an aperture in the collimating channel to receive light emitted from the plasma between the end of the elongated section of the support arm and the inner charge collection plate.

The electrical probe element acts as a blocking element to block light emitted from the plasma outside of the region between the electrical probe element and the end of the support arm section. Electrical wires extend through the probe from the charge collection plates to charge detectors, allowing measurements of electron density, Electron Energy Distribution Function and ion flow. The light received by the optical fiber is detected by a spectrometer to carry out Optical Emission Spectroscopy, which can be correlated with the information obtained from the charge collection plates. The probe can be moved around a plasma confinement chamber to provide spatially localized measurements of plasma characteristics at various positions within the chamber.

There is also known a confocal X-ray fluorescence (XRF) microscopy (Dehlinger et al. Spatial resolution of confocal XRF technique using capillary optics. Nanoscale Research Letters 2013, 8:271). XRF is a powerful technique for elemental analysis with a high sensitivity. The spatial resolution is presently limited by the size of the primary excitation X-ray beam. A confocal-type XRF has been used to estimate the ultimate lateral resolution which could be reached in chemical mapping of a sample using this technique. A polycapillary lens is used to tightly focus the primary X-ray beam of X-ray source, while the fluorescence signal is collected by a silicon drift detector (SDD) through a cylindrical monocapillary. This system was used to characterize the geometry of the fluorescent zone. Capillary radii ranging from 50 µm down to 5 µm were used to investigate the fluorescence signal maximum level This study allows to estimate the ultimate resolution which could be reached in-lab or on a synchrotron beamline. A new tool combining local XRF and scanning probe microscopy is finally proposed.

### Disclosure of Invention

This invention relates to X-ray fluorescence mapping analysis methods, which measure distribution of elements (mixed gases and/or sputtered elements) by irradiating the subject with an X-ray beam and by local detection through the X-ray focusing polycapillaries the X-rays induced fluorescence from a selected pixel of the total subject in a chamber of low-temperature plasma or vacuum evaporation or sputtering processes. The invention provides also for 2D and 3D mapping.

One particular embodiment of the present invention provides a local 3D mapping of low-temperature plasma and/or vacuum sputtering process using X-ray fluorescence emission local detection probe (LXRF - local XRF spectroscopy), which is located directly in plasma area above magnetron and spatially scans plasma to provide *in situ* a 3D process control and mapping. Another embodiment provides a local 3D mapping of evaporated material using X-ray fluorescence emission local detection probe (LXRF - local XRF spectroscopy), which is located between the evaporation source and the substrate and spatially scans the flux of evaporated material to provide *in situ* a 3D process control and mapping.

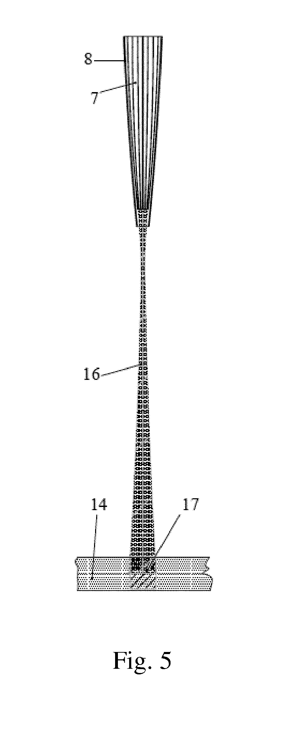

There is proposed a device for diagnostic of plasma and/or flux of sputtered or evaporated particles of material, comprising: a probe unit adapted to be placed outside or inserted into a plasma and/or a flux of sputtered or evaporated particles of material and adapted to direct signals from a signal supplying unit to a signal detecting unit; a means for processing the detected signals and interpreting the signals received, where the device comprises: a source adapted for generating plasma and/or creating a flux of sputtered or evaporated particles of material (the source may be movable); an X-ray source adapted to send a collimating beam through the plasma and/or the flux of sputtered or evaporated particles; a movable X-ray fluorescence polycapillary confocal probe, comprising an X-ray optic, being accommodated in a casing; where the probe is adapted to collect the XRF signal in the "confocal mode", i.e. from an intersect of the collimated beam provided by the X-ray source and the line of sight of the confocal probe (Fig. 5); an X-ray energy sensitive detector being optically connected with the probe such as to enable the X-ray optic to direct X-rays towards the detector from the optic's input end facing the beam. In addition to the X-ray fluorescence probe the device may contain a set of optical emission probes, which input ends are adapted to be facing the plasma and output end are optically connected with optical signal detecting unit, which in turn is connected with means for processing the detected signals and interpreting the signals received.There is also proposed a method of diagnostic plasma and/or flux of sputtered or evaporated particles of material, comprising detection of X-ray fluorescence signals of plasma and/or flux of sputtered or evaporated particles of material by a signal supplying unit to a signal detecting unit, processing the detected signals and interpreting the signals received, wherein sending signals through plasma and/or flux of sputtered or evaporated particles of material by a signal supplying unit to a signal detecting unit comprises: (i) generating plasma and/or creating a flux of sputtered or evaporated particles of material inside a vacuum chamber; (ii) sending a collimating beam by an X-ray source through the plasma and/or the flux of particles; (iii) inserting an X-ray fluorescence probe into the plasma and/or into a flux of sputtered or evaporated material intersecting the beam collimated by the X-ray source by a line of sight of the X-ray fluorescence probe; or disposing an X-ray fluorescence probe at or near a boundary of plasma and/or a flux of sputtered or evaporated material intersecting the beam collimated by the X-ray source by a line of sight of the X-ray fluorescence probe; (iv) directing collected X-rays by the probe's input end facing the beam towards an X-ray energy sensitive detector; (v) moving the probe within or at a boundary of plasma and/or a flux of sputtered or evaporated material, facing the probe's input end toward the collimated beam being sent by the X-ray source through the plasma or flux of particles; optionally, or alternatively - moving the source generating plasma or creating a flux of sputtered or evaporated particles of material inside a vacuum chamber. At the step (v) the probe can be moved to x- and y- axis directions within or at a boundary of plasma and/or a flux of sputtered or evaporated material, facing the probe's input end toward the beam being collimated by the X-ray source through the plasma or flux of particles, where the source generating plasma or creating a flux of sputtered or evaporated particles of material is also being moved to z- axis direction. Alternativly, at the step (v) the probe can be moved to x-, y-and z- axis directions within or at a boundary of plasma and/or a flux of sputtered or evaporated material, facing by the probe's input end the beam being collimated by the X-ray source through the plasma and/or flux of particles; also moving to z- axis direction the X-ray source sending the collimating beam, so that the X-ray source and the probe would be moved in z-axis direction synchronously.

### Brief Description of Drawings

Fig. 1 shows a schematic structure of a plasma device adapted for 3D plasma mapping, using local X-ray fluorescence probe;
Fig. 2 shows the AA cross-section of the plasma device showing chamber with a magnetron, X-ray source and a collimated beam;
Fig. 3 shows a section of the X-ray fluorescence (XRF) probe comprising a screen casing and a polycapillary optic being accommodated in it;
Fig. 4 shows another embodiment of the device comprising X-ray fluorescence polycapillary probe combined with set of optical probes (cross-section).
Fig. 5 shows the scheme of collection the XRF signal from an intersect of the collimated beam provided by the X-ray source and line of sight of the X-ray fluorescence (XRF) probe.

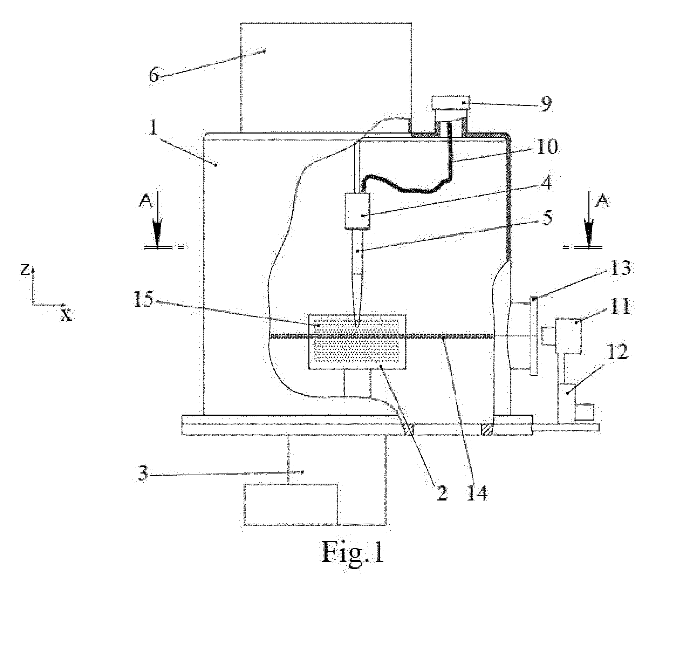

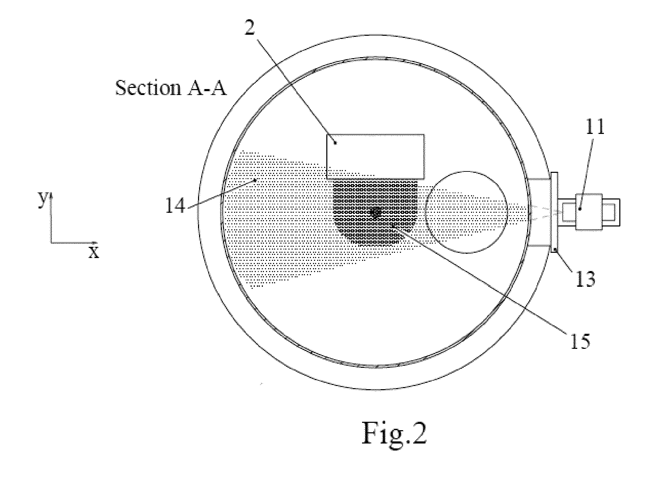

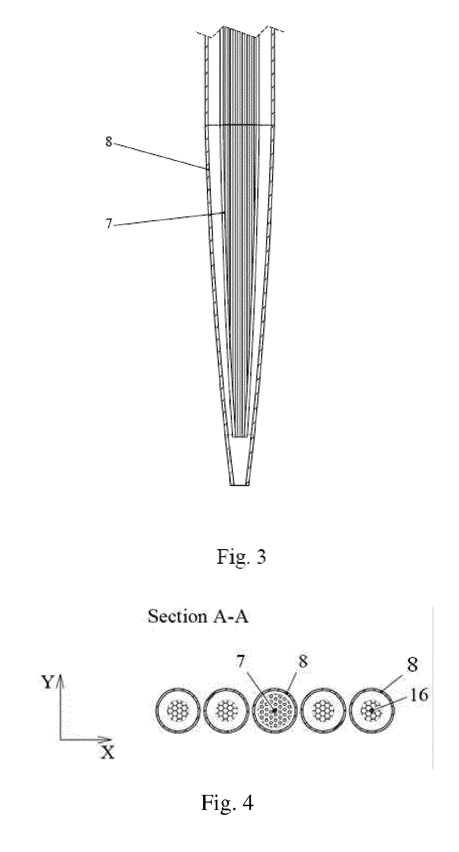

A plasma and/or flux of sputtered or evaporated particles of material diagnostic device (Fig. 1 and 2) adapted for 3D plasma or flux of particles mapping, using local X-ray fluorescence probe comprises: a vacuum chamber 1; a source 2 adapted for generating plasma or creating a flux of sputtered or evaporated particles of material (the source 2 can be a magnetron or a thermal evaporation source, or an electron beam evaporation source); the source 2 can be provided with a z-axis manipulator 3; an X-ray energy sensitive detector 4 (e.g. Silicon drift detector); a movable XRF fluorescence confocal probe 5 provided with at least x- and y- axis (optionally - also z-axis) manipulator 6 (meaning that the probe 5 can be moved in x-, y- and z- axis directions as shown in Fig. 1 and 2), the probe 5 comprising a polycapillary X-ray optic 7, being accommodated in a casing 8 (Fig. 3), which is adapted to protect the probe 5 from external factors. The plasma device further comprising an optical detector 9 being optically connected with the detector 4 by means of an optical fibre 10; a X-ray source 11 (optionally-movable and provided with z-axis manipulator 12).

The polycapillary X-ray optic 7 is adapted for directing X-rays towards the X-ray energy sensitive detector 4, the optic 7 having an input (plasma x-ray exited) end facing a beam collimated by the X-ray source 11 and an output end facing the X-ray detector 4. The casing 8 has an opening at an end one, where the optic's 7 end facing x-ray source is located and an opening at an end two, where the optic's 7 output end facing the X-ray detector is located.

The chamber 1 has a (beryllium) window 13, against which the X-ray source 11 (X-ray tube or synchrotron radiation) is positioned. The X-ray source 11 is adapted to provide a (collimated) beam 14 through the plasma. The window 13 is located on the side of the chamber 1, which is opposite to plasma 15 induced by the source 2. The X-ray source can be movable in z direction.

The probe 5 is located next to the source 2, such that its input end can be located in plasma 15 induced by the source 2 and facing the beam 14 provided by the X-ray source 11. The direction of X-ray beam 14 from the source 11 in plasma 15 can be changed by the z-axis manipulator 12.

The 2D mapping can be preferably ensured either (i) by movement of the probe 5 in x- and y- axis directions, or (ii) by movement of the source 2 in any of two: x-/y-/z- axis directions, or (iii) by movement of the probe 5 and the source 2, each in own direction (if the probe is being moved in z- axis direction, the X-ray source 11 also should be moved in z-axis direction).

The 3D mapping can be preferably ensured either (i) by movement of the probe 5 in x- and y- axis directions and movement of the source 2 in z- axis direction, or (ii) by movement of the probe 5 in x-, y- and z- axis directions and movement of the X-ray source 11 in z-axis direction or by by movement of the probe 5 in x- and y- axis directions and movement of the X-ray source 11 in z-axis direction.

The XRF detection gives directly the concentration of the elements in the sample (plasma) not being dependant indirectly on the plasma parameters (temperature, current, etc.). The X-ray flux density obtained by X-ray policallary optics is some orders of magnitude higher than that obtained with a conventional pinhole collimator.

The offered XRF detection probe 5 also may concurrently contain other local plasma parameters detection systems, such as quartz crystal micro-balance, optical emission probes 16 (Fig. 4) or Langmuir probe. In case of combination of the XRF probe with a set of optical emission probes 16 (the probes 16 may be provided with screen casing 8 similar to casing of the X-ray optic 7), the optical emission probes 16 can be also provided with screens fixed at a distance from the probes' input end to screen the radiation from parts of plasma other than the measured volume.

The XRF method is developed to determine directly the distribution and concentrations of the elements in the plasma of magnetron sputtering discharge. In a specific example, XRF was applied to magnetron sputtering of Zn target in a mixture of argon and oxygen. Preliminary measurements were performed with a spatial resolution of 5 mm. They showed significant variation in the local plasma composition.

The invention also provides a plasma process control by a microprocessor, using information obtained from the XRF and other devices.

### Example of implementation of the Invention

The XRF local probe was positioned vertically in the direction of Z axis as shown in Fig. 1, and X, Y raster scanned from x, y= 0 mm up to x, y = 200 mm from the edge of magnetron by the increments Δr = 5 mm with computer controlled stepper motor, which is synchronized with a data recorder system. Further the magnetron was moved in z direction and the next probe raster scanning was performed. Axis lines cover an area from z = 5 mm in the vicinity of the target up to z = 100 mm relatively far from it. Measurement sites are shown by location of points in Fig. 1. The given increments was Δz = 10 mm in area z = between 10 and 100 mm. Thus defined target area covers most typical base position.

## Claims

1. A device for diagnostic of plasma and/or flux of sputtered or evaporated particles of material, comprising: a probe unit adapted to be placed outside or inserted into a plasma and/or a flux of sputtered or evaporated particles of material and adapted to direct signals from a signal supplying unit to a signal detecting unit; a means for processing the detected signals and interpreting the signals received, **characterized in that** the device comprises:
- a source (2) adapted for generating plasma and/or creating a flux of sputtered or evaporated particles of material;
- a X-ray source (11) adapted to send a collimating beam (14) through the plasma and/or the flux of sputtered or evaporated particles;
- a movable X-ray fluorescence polycapillary confocal probe (5) provided with at least an x- and y- axis manipulator (6), the probe (5) comprising an X-ray optic (7), being accommodated in a casing (8); where the probe (5) is adapted to collect the XRF signal from an intersect (17) of the collimated beam (14) provided by the X-ray source (11) and a line of sight (16) of the probe (5);
- a X-ray energy sensitive detector (4) being optically connected with the probe (5) such as to enable the X-ray optic (7) to direct X-rays towards the detector (4) from the optic's (7) input end facing the beam (14).

2. The device according to claim 1, wherein the source (2) is provided with z- axis manipulator (3) allowing the source (2) to be moved in z- axis direction.

3. The device according to claim 1, wherein the probe (5) is provided with x-, y-, z- axis manipulator (6), allowing the probe (5) to be moved in x-, y-, z- axis directions, where the X-ray source (11) is provided with a z-axis manipulator (12) allowing the source (11) to be movable in z-axis direction; wherein the device is adapted to move the probe (5) and the source (11) in z- axis direction synchronously.

4. The device according to any preceding claims, wherein in addition to the X-ray fluorescence probe (5) it contains a set of optical emission probes (16), which input ends are adapted to be facing the plasma and output end are optically connected with optical signal detecting unit, which in turn is connected with means for processing the detected signals and interpreting the signals received.

5. A method of diagnostic plasma and/or flux of sputtered or evaporated particles of material, comprising detection of X-ray fluorescence signals of plasma and/or flux of sputtered or evaporated particles of material by a signal supplying unit to a signal detecting unit, processing the detected signals and interpreting the signals received, wherein sending signals through plasma and/or flux of sputtered or evaporated particles of material by a signal supplying unit to a signal detecting unit comprises:
(i) generating plasma and/or creating a flux of sputtered or evaporated particles of material inside a vacuum chamber (1),
(ii) sending a collimating beam by an X-ray source (11) through the plasma and/or the flux of particles,
(iii) inserting an X-ray fluorescence probe (5) into the plasma and/or into a flux of sputtered or evaporated material intersecting (17) the beam collimated by the X-ray source (11) by a line of sight (16) of the X-ray fluorescence probe (5); or disposing an X-ray fluorescence probe (5) at or near a boundary of plasma and/or a flux of sputtered or evaporated material intersecting (17) the beam collimated by the X-ray source (11) by a line of sight (16) of the X-ray fluorescence probe (5);
(iv) directing collected X-rays by the probe's (5) input end facing the beam towards an X-ray energy sensitive detector (4);
(v) moving the probe (5) within or at a boundary of plasma and/or a flux of sputtered or evaporated material, facing the probe's (5) input end toward the collimated beam being sent by the X-ray source (11) through the plasma or flux of particles; optionally, or alternatively - moving the source (2) generating plasma or creating a flux of sputtered or evaporated particles of material inside a vacuum chamber.

6. The method according to claim 5, wherein at the step (v) the probe (5) is being moved to x- and y- axis directions within or at a boundary of plasma and/or a flux of sputtered or evaporated material, facing the probe's (5) input end toward the beam being collimated by the X-ray source (11) through the plasma or flux of particles, where the source (2) generating plasma or creating a flux of sputtered or evaporated particles of material is also being moved to z- axis direction.

7. The method according to claim 5, wherein at the step (v) the probe (5) is being moved to x-, y- and z- axis directions within or at a boundary of plasma and/or a flux of sputtered or evaporated material, facing by the probe's (5) input end the beam being collimated by the X-ray source (11) through the plasma and/or flux of particles; also moving to z- axis direction the X-ray source (11) sending the collimating beam, so that the X-ray source (11) and the probe (5) would be moved in z-axis direction synchronously.

8. The method according to claim 5, further comprising the following steps being conducted together with the respective steps of claim 5: (iv) directing optical signals from the optical emission probes input end facing the plasma towards a light sensitive detector; (v) moving the optical emission probes within or at a boundary of plasma or flux of particles.
